(19) Europäisches Patentamt
European Patent Office
Office européen des brevets

(11) EP 4 722 747 A1

(12) DEMANDE DE BREVET EUROPEEN

(43) Date de publication:
08.04.2026 Bulletin 2026/15

(21) Numéro de dépôt: 25199799.5

(22) Date de dépôt: 03.09.2025

(51) Classification Internationale des Brevets (IPC):
$G01R\ 31/392$ (2019.01)    $G01R\ 31/396$ (2019.01)

(52) Classification Coopérative des Brevets (CPC):
G01R 31/392; G01R 31/396

(84) Etats contractants désignés:
AL AT BE BG CH CY CZ DE DK EE ES FI FR GB
GR HR HU IE IS IT LI LT LU LV MC ME MK MT NL
NO PL PT RO RS SE SI SK SM TR
Etats d'extension désignés:
BA
Etats de validation désignés:
GE KH LA MA MD TN

(30) Priorité: 03.10.2024 FR 2410652

(71) Demandeur: Commissariat à l'Energie Atomique
et aux Energies
Alternatives
75015 Paris (FR)

(72) Inventeurs:
• DESEURE, Jonathan
38054 GRENOBLE CEDEX 09 (FR)
• KLEIN, Jean-Marie
38054 GRENOBLE CEDEX 09 (FR)
• LONARDONI, Loic
38054 GRENOBLE CEDEX 09 (FR)

(74) Mandataire: Santarelli
Tour Trinity
1 bis Place de la Défense
92400 Courbevoie (FR)

(54) **MÉTHODE ET DISPOSITIF POUR DÉTECTER UNE DÉFAILLANCE D'UNE BATTERIE LITHIUM-ION**

(57) Méthode (100) pour détecter une défaillance d'une batterie Lithium-Ion. La méthode comporte, pour au moins une phase de relaxation de la batterie, et pour chaque cellule de la batterie :
- une collecte (110) de plusieurs mesures de tension de la cellule,
- une formation (120) d'un signal de relaxation sous la forme d'un logarithme d'une valeur normalisée de la tension de la cellule,
- une décomposition (130) en modes empiriques (EMD) du signal de relaxation en composantes intrinsèques.
    La méthode (100) comporte également :
- une détermination (150) d'une valeur d'incidence représentative d'un état de santé de la batterie à partir des composantes intrinsèques obtenues pour les différentes cellules,
- une évaluation (160) d'un critère de détection d'une défaillance de la batterie en fonction de la valeur d'incidence.

[Fig. 2]

Pour au moins une phase de relaxation :

Pour chaque cellule :

Collecte de plusieurs mesures de tension pendant la phase de relaxation — 110

Formation d'un signal relaxation — 120

Décomposition en modes empiriques (EMD) du signal de relaxation — 130

Analyse de fiabilité statistique — 140

Détermination d'une valeur d'incidence à partir des composantes intrinsèques des décompositions EMD obtenues pour les différentes cellules de la batterie — 150

Evaluation d'un critère de détection d'une défaillance de la batterie — 160

Vérification si la défaillance détectée est liée à l'environnement dans lequel la cellule a évolué — 170

100

## Description

## Domaine de l'invention

La présente invention appartient au domaine de la gestion des batteries de type « Lithium-Ion ». Plus particulièrement, il est proposé une méthode et un dispositif pour détecter une défaillance d'une batterie Lithium-Ion.

## Etat de la technique

Le domaine du stockage d'énergie, avec notamment l'usage de batteries Lithium-Ion, est actuellement en plein essor. Cet essor est favorisé en grande partie par le développement des véhicules électriques, qui intègrent généralement des batteries dites de première vie (batteries avec un état de santé, ou SOH pour « State Of Health » en anglais, proche de 100% en début d'usage), mais aussi par le secteur du stockage stationnaire, notamment pour des applications de soutien du réseau électrique, avec l'usage de batteries neuves, mais aussi de batteries dites de seconde vie (batteries présentant un état de santé plus faible en début d'usage, par exemple un SOH inférieur à 80%). Les batteries de seconde vie utilisées pour la régulation du réseau électrique sont souvent issues de la réutilisation de batteries de véhicules électriques.

Au cours de leur vie, les batteries subissent des dégradations. Il est important de pouvoir détecter les signes de ces dégradations afin d'anticiper d'éventuelles pannes ou problèmes de sécurité. Cela permet également de déterminer si une batterie peut être réutilisée en deuxième vie. La réutilisation d'une batterie en deuxième vie est possible si elle n'a pas subi trop de défaillances au cours de sa première vie.

Il existe différentes méthodes de détection de défaillances des batteries au lithium.

Certaines méthodes se basent sur des mesures de propriétés mécaniques de la batterie (vibrations, ondes acoustiques, etc.). Ces mesures peuvent être utilisées pour identifier des signes précoces de défaillance, tels que des fissures, des délaminations et des défauts de fabrication.

Certaines méthodes se basent sur des mesures de propriétés thermiques de la batterie, telles que la température, la conductivité thermique et la capacité thermique. Ces mesures peuvent être utilisées pour identifier un échauffement anormal de la batterie. Un inconvénient de ces méthodes est que la défaillance est généralement détectée de façon assez tardive.

D'autres méthodes se basent sur des mesures des propriétés électrochimiques de la batterie, telles que la tension, le courant, la résistance ou la capacité. En particulier, de nombreuses méthodes se basent sur des signaux de tension mesurés au niveau de la batterie. On peut citer par exemple les demandes de brevet US 2017/146608 A1, US 2022/0381849 A1 et EP 3324197 A1.

La fiabilité des méthodes existantes n'est toutefois pas toujours pleinement satisfaisante. D'autre part, les systèmes de gestion de batterie (BMS pour « Battery Management System » en anglais) fournissent parfois un nombre de données assez limité, et il convient de trouver une méthode de détection de défaillance assez simple qui puisse s'appliquer à la majorité des systèmes de gestion de batterie existants.

## Exposé de l'invention

La présente invention a pour objectif de remédier à tout ou partie des inconvénients de l'art antérieur, notamment ceux exposés ci-avant, en proposant une méthode de détection de défaillance d'une batterie Lithium-Ion. La méthode proposée présente une bonne fiabilité et elle peut être mise en œuvre par la majorité des systèmes de gestion de batterie existants.

A cet effet, et selon un premier aspect, il est proposé une méthode pour détecter une défaillance d'une batterie Lithium-Ion comportant plusieurs cellules. La méthode comporte, pour au moins une phase de relaxation faisant suite à une phase de décharge de la batterie :

- pour chaque cellule :

  ◦ une collecte de plusieurs mesures de tension au niveau de la cellule pendant ladite phase de relaxation,
  ◦ une formation d'un signal de relaxation en calculant, pour chaque mesure de tension collectée pendant ladite phase de relaxation, un logarithme d'une valeur normalisée de la mesure de tension,
  ◦ une décomposition en modes empiriques du signal de relaxation afin d'en obtenir une représentation sous la forme d'une somme d'un signal résiduel et d'une ou plusieurs composantes intrinsèques,

- une détermination d'une valeur d'incidence représentative d'un état de santé de la batterie, pour ladite phase de relaxation, à partir des composantes intrinsèques ainsi obtenues pour les différentes cellules de la batterie,
- une évaluation d'un critère de détection d'une défaillance de la batterie en fonction de la valeur d'incidence de ladite phase de relaxation.

Selon un premier exemple, la solution proposée permet de détecter une défaillance de la batterie au moment où la défaillance se produit. La défaillance peut par exemple être due à un vieillissement anormal de la batterie ou à des conditions environnementales anormales. Lorsqu'une défaillance est détectée, des mesures peuvent être prises pour optimiser la durée de vie de la batterie, ou pour la mettre en sécurité.

Selon un autre exemple, la solution proposée permet d'évaluer un état de santé de la batterie à la fin d'une première vie de la batterie, en fonction de défaillances détectées a posteriori. Les défaillances subies par la batterie au cours de sa première vie peuvent être détectées à partir de valeurs d'incidence mémorisées tout au long de la première vie de la batterie. Cette cartographie des défaillances subies par la batterie au cours de sa première vie peut permettre de déterminer s'il est envisageable de réutiliser la batterie pour une seconde vie, avec une application éventuellement différente.

Dans des modes particuliers de mise en œuvre, la méthode peut comporter en outre l'une ou plusieurs des caractéristiques suivantes, prises isolément ou selon toutes les combinaisons techniquement possibles.

Dans des modes particuliers de mise en œuvre, pour une cellule d'indice *k*, une valeur du signal de relaxation à un instant *t* peut s'écrire sous la forme :

$$x_k(t) = -\ln\left(\frac{V_k(t)}{\left(\frac{U_B(t)}{N_C}\right)}\right)$$

où $V_k(t)$ est une tension mesurée aux bornes de la cellule d'indice *k*, $U_B(t)$ est une tension mesurée aux bornes de la batterie, $N_C$ est le nombre de cellules de la batterie, et ln est l'opérateur logarithme népérien.

Dans des modes particuliers de mise en œuvre, la détermination de la valeur d'incidence pour la phase de relaxation considérée comporte :

- pour chaque composante intrinsèque d'une cellule, un calcul d'une énergie de ladite composante intrinsèque,
- pour chaque cellule, un calcul d'une énergie de la cellule correspondant à une somme des énergies des composantes intrinsèques de la cellule,
- un calcul d'une énergie moyenne correspondant à une moyenne des énergies des cellules de la batterie,
- une détermination de la valeur d'incidence à partir de l'énergie moyenne calculée pour la phase de relaxation considérée.

Dans des modes particuliers de mise en œuvre, l'évaluation d'un critère de détection comporte une comparaison de la valeur d'incidence avec un seuil d'incidence prédéterminé, pour une ou plusieurs phases de relaxation consécutives.

Dans des modes particuliers de mise en œuvre, l'évaluation d'un critère de détection comporte une comparaison de la valeur d'incidence avec une ou plusieurs valeurs d'incidence de phases de relaxation précédentes.

Dans des modes particuliers de mise en œuvre, l'évaluation d'un critère de détection comporte une vérification si les valeurs d'incidence de plusieurs phases de relaxation consécutives sont croissantes pour un nombre prédéterminé de phases de relaxation consécutives.

Dans des modes particuliers de mise en œuvre, l'évaluation d'un critère de détection comporte un calcul d'une pente d'une interpolation linéaire effectuée pour un ensemble de plusieurs valeurs d'incidence correspondant à plusieurs phases de relaxation consécutives, et une comparaison de la pente avec un seuil de pente prédéterminé.

Dans des modes particuliers de mise en œuvre, la méthode comporte en outre, pour chaque phase de relaxation, une analyse de fiabilité statistique d'éléments permettant la détermination de la valeur d'incidence, et un filtrage de l'un au moins des éléments suivants s'il est jugé non fiable :

- une composante intrinsèque d'une cellule,
- une cellule de la batterie,
- la valeur d'incidence.

Dans des modes particuliers de mise en œuvre, l'analyse de fiabilité statistique comporte, pour chaque composante intrinsèque du signal de relaxation d'une cellule, un calcul d'une entropie de la composante intrinsèque.

Dans des modes particuliers de mise en œuvre, l'analyse de fiabilité statistique comporte, pour chaque cellule, un calcul d'une entropie à partir d'une somme des composantes intrinsèques du signal de relaxation de la cellule.

Dans des modes particuliers de mise en œuvre, l'analyse de fiabilité statistique comporte :

- une comparaison d'une énergie d'une composante intrinsèque d'une cellule avec un seuil ou avec les énergies des autres composantes intrinsèques de la cellule, et/ou

- une comparaison d'une énergie d'une cellule avec un seuil ou avec les énergies des autres cellules de la batterie, et/ou

- une comparaison de la valeur d'incidence déterminée pour la phase de relaxation considérée avec un seuil ou avec d'autres valeurs d'incidence calculées pour des phases de relaxation précédentes.

Dans des modes particuliers de mise en œuvre, lorsqu'une défaillance est détectée, la méthode comporte en outre une vérification si la défaillance détectée est liée à l'environnement dans lequel la batterie a évolué.

Dans des modes particuliers de mise en œuvre, la vérification si la défaillance détectée est liée à l'environnement comprend une comparaison, pour une période donnée comportant ladite au moins une phase de relaxation, de valeurs d'incidence déterminées pour la batterie pendant ladite période avec des valeurs d'incidence déterminées pour au moins une autre batterie soumise au même environnement pendant ladite période.

Dans des modes particuliers de mise en œuvre, la vérification si la défaillance détectée est liée à l'environnement comprend une comparaison, pour une période donnée comportant ladite au moins une phase de relaxation, de mesures d'environnement effectuées pendant ladite période avec un seuil prédéterminé.

Dans des modes particuliers de mise en œuvre, lorsqu'une défaillance est détectée, la méthode (100) comporte une mémorisation de l'occurrence de la défaillance, pour une analyse a posteriori d'un état de santé de la batterie

Dans des modes particuliers de mise en œuvre, la phase de décharge qui précède la phase de relaxation présente une profondeur de décharge au moins égale à 60%, voire de préférence au moins égale à 90%.

Selon un deuxième aspect, il est proposé un dispositif pour détecter une défaillance d'une batterie Lithium-Ion comportant plusieurs cellules. Le dispositif comporte :

- un système de mesure configuré pour fournir des mesures de tension effectuées au niveau de chaque cellule pendant au moins une phase de relaxation faisant suite à une décharge de la batterie,
- une unité de calcul connectée au système de mesure.

L'unité de calcul est configurée pour mettre en œuvre la méthode selon l'un quelconque des modes de mise en œuvre précédents.

Selon un troisième aspect, il est proposé un système de gestion de batterie, ou BMS, comportant un dispositif tel que décrit ci-avant.

**Présentation des figures**

L'invention sera mieux comprise à la lecture de la description suivante, donnée à titre d'exemple nullement limitatif, et faite en se référant aux figures suivantes :

[Fig. 1] un graphique représentant l'évolution en fonction du temps de la tension mesurée aux bornes d'une batterie Lithium-Ion, ainsi que des tensions mesurées aux bornes de chaque cellule de la batterie,
[Fig. 2] une représentation schématique des principales étapes d'un exemple de mise en œuvre de la méthode selon l'invention pour détecter une défaillance d'une batterie Lithium-Ion,
[Fig. 3] un graphique représentant un signal de relaxation, ainsi que le signal résiduel issue de la décomposition en mode empirique de ce signal de relaxation,
[Fig. 4] un graphique représentant quatre composantes empiriques obtenues par la décomposition en mode empirique du signal de relaxation représenté à la figure 3, [Fig. 5] un mode particulier de mise en œuvre de la détermination d'une valeur d'incidence représentative d'un état de santé de la batterie, pour une phase de relaxation donnée,
[Fig. 6] un graphique représentant des valeurs d'incidence, associées aux dates des phases de relaxation pour lesquelles elles ont été déterminées, pour différentes batteries soumises à différentes conditions environnementales et à différents usages pendant une période donnée,
[Fig. 7] un premier graphique représentant l'évolution au cours du temps de la valeur d'incidence d'une batterie ainsi que l'évolution au cours du temps, pendant la même période, de la température subie par la batterie,
[Fig. 8] un deuxième graphique représentant l'évolution au cours du temps de la valeur d'incidence d'une batterie ainsi que l'évolution au cours du temps, pendant la même période, de la température subie par la batterie,
[Fig. 9] une représentation schématique d'un dispositif selon l'invention permettant de détecter une défaillance d'une batterie Lithium-Ion.

Dans ces figures, des références identiques d'une figure à une autre désignent des éléments identiques ou analogues. Pour des raisons de clarté, les éléments représentés ne sont pas nécessairement à une même échelle, sauf mention contraire.

**Description détaillée de l'invention**

Pour détecter une défaillance d'une batterie Lithium-Ion, la méthode selon l'invention exploite les signaux de tension des différentes cellules de la batterie. Les signaux de tension sont mesurés au cours de phases de relaxation de la batterie. Une phase de relaxation fait suite à une phase de décharge plus ou moins complète de la batterie.

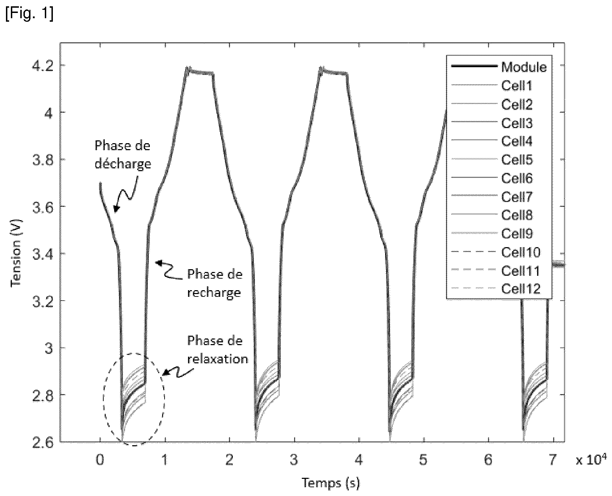

La figure 1 est un graphique représentant l'évolution en fonction du temps de la tension mesurée aux bornes d'une batterie Lithium-Ion, ainsi que les tensions mesurées aux bornes de chaque cellule de la batterie. Dans l'exemple considéré et illustré à la figure 1, la batterie comporte douze cellules. La figure 1 représente quatre phases de relaxation. Chaque phase de relaxation fait suite à une phase de décharge de la batterie et précède une phase de recharge de la batterie. Rien n'empêcherait toutefois de considérer une phase de relaxation intercalée entre deux phases de décharges. Pendant chaque phase de relaxation, on peut observer que les signaux de tension des différentes cellules prennent des valeurs différentes (ils suivent une tendance similaire mais avec des valeurs différentes). Pendant les phases de décharge et les phases de recharge, les signaux de tension des différentes cellules sont sensiblement confondus avec le signal de tension de la batterie.

D'un point de vue de la physique, les travaux publiés dans le document « Anisotropic ionic transport properties in solid PEO based electrolytes », R. Jeanne-Brou et al., permettent de relier l'évolution de la tension en fonction du temps à la diffusion des espèces électroactives vers les lieux de transfert de charge. L'état de santé (SOH) d'une batterie peut avoir un impact sur cette évolution. C'est la raison pour laquelle les inventeurs ont décidé de s'intéresser à la tension de relaxation des cellules d'une batterie au Lithium, et plus particulièrement au logarithme d'une valeur normalisée de la tension.

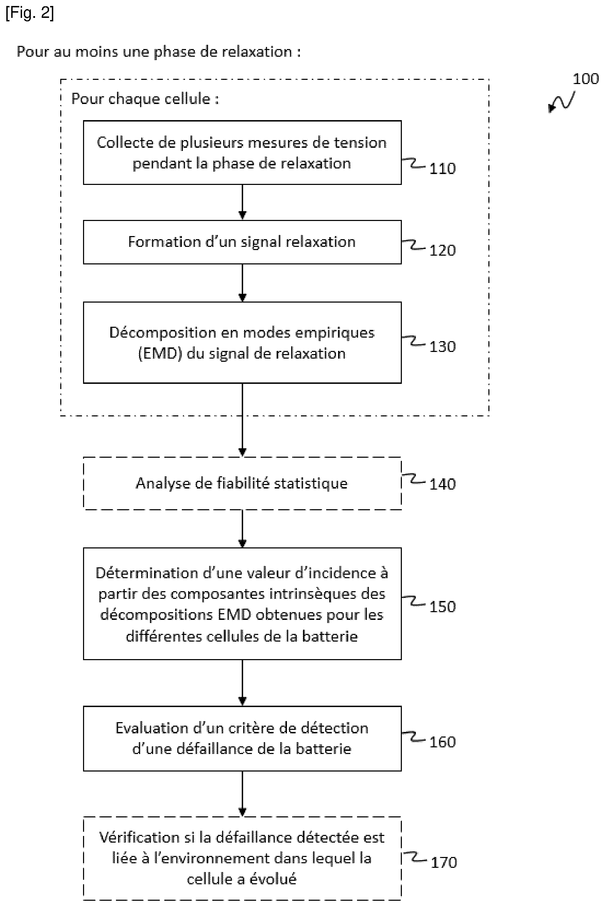

La figure 2 représente schématiquement les principales étapes d'un exemple de mise en œuvre d'une méthode 100 selon l'invention pour détecter une défaillance d'une batterie Lithium-Ion.

Tel qu'illustré sur la figure 2, la méthode 100 comporte, pour au moins une phase de relaxation :

- pour chaque cellule:

  ○ une collecte 110 de plusieurs mesures de tension au niveau de la cellule pendant la phase de relaxation,
  ○ une formation 120 d'un signal de relaxation en calculant, pour chaque mesure de tension collectée pendant la phase de relaxation, un logarithme d'une valeur normalisée de la mesure de tension,
  ○ une décomposition 130 en modes empiriques du signal de relaxation afin d'en obtenir une représentation sous la forme d'une somme d'un signal résiduel et d'une ou plusieurs composantes intrinsèques,

- une détermination 150 d'une valeur d'incidence représentative d'un état de santé de la batterie, pour la phase de relaxation considérée, à partir des composantes intrinsèques ainsi obtenues pour les différentes cellules de la batterie,
- une évaluation 160 d'un critère de détection d'une défaillance de la batterie en fonction de la valeur d'incidence de la phase de relaxation.

Ces différentes étapes peuvent être mises en œuvre pour chaque phase de relaxation qui suit une phase de décharge de la batterie au cours de sa vie. Rien n'empêcherait toutefois, dans une variante, de mettre en œuvre ces étapes uniquement pour un sous-ensemble des phases de relaxation. En particulier, les inventeurs ont pu observer que plus la phase de décharge qui précède la phase de relaxation est importante, et plus la valeur d'incidence obtenue pour cette phase de relaxation est pertinente. C'est pourquoi il peut être envisagé, par exemple, de considérer uniquement les phases de relaxation qui font suite à une phase de décharge présentant une profondeur de décharge (DOD pour « Depth Of Discharge » en anglais) au moins égale à 60%. Une profondeur de décharge de 60% signifie que l'état de charge de la batterie (SOC pour « State Of Charge » en anglais) est de 40% (SOC = 1 - DOD). De façon encore plus optimale, on peut considérer uniquement les phases de relaxation qui font suite à une phase de décharge présentant une profondeur de décharge au moins égale à 90%.

Les mesures de tension pendant la phase de relaxation sont par exemple effectuées par un système de gestion de batterie (BMS pour « Battery Management System » en anglais) connecté aux cellules de la batterie. Les mesures sont par exemple effectuées avec une fréquence d'acquisition comprise entre cinq et soixante secondes, pendant une durée d'acquisition de trente à soixante minutes. Rien n'empêcherait toutefois de faire les mesures avec une fréquence d'acquisition différente, et/ou pendant une durée d'acquisition différente. Il est avantageux d'utiliser un nombre de mesures compris entre quarante et deux-cents par phase de relaxation (utiliser un plus grand nombre de mesures n'implique pas nécessairement une amélioration significative de la méthode, utiliser un nombre de mesures plus faible peut en revanche limiter les performances de la méthode).

L'étape de formation 120 du signal de relaxation comporte, pour chaque mesure de tension collectée pendant la phase de relaxation, un calcul d'un logarithme d'une valeur normalisée de la mesure de tension. Par exemple, le signal de relaxation d'une cellule d'indice $k$ peut s'écrire sous la forme :

$$x_k(t) = -\ln\left(\frac{V_k(t)}{\left(\frac{U_B(t)}{N_C}\right)}\right)$$

où $V_k(t)$ est la tension mesurée aux bornes de la cellule d'indice $k$, $U_B(t)$ est la tension mesurée aux bornes de la batterie, $N_C$ est le nombre de cellules de la batterie, et ln est l'opérateur logarithme népérien.

Rien n'empêcherait, dans des variantes, de définir le signal de relaxation d'une façon différente, notamment en changeant la façon de normaliser la tension mesurée aux bornes d'une cellule, ou en utilisant un logarithme dans une base différente (par exemple dans une base égale à $N_C$). Pour la normalisation, on pourrait par exemple envisager d'utiliser un polynôme caractéristique de la tension moyenne de relaxation de la batterie (par exemple de type $\overline{\overline{U}}_B(t) = at + b$), ou d'utiliser simplement une valeur moyenne $\langle U_B \rangle$ de la tension de la batterie pendant la phase de relaxation.

A l'étape 130, le signal de relaxation est décomposé selon une décomposition en modes empiriques (EMD pour « Empirical Mode Decomposition » en anglais).

La décomposition en modes empiriques consiste à décomposer un signal sous la forme d'une somme de fonctions, de façon similaire à ce que fait la décomposition en série de Fourier ou la décomposition en ondelettes.

Une des particularités de la décomposition en modes empiriques est que la base de fonctions en lesquelles le signal est décomposé n'est pas connue a priori, mais elle est construite de façon adaptative en fonction des propriétés du signal.

La décomposition en modes empiriques correspond à la première partie de la transformée de Hilbert-Huang (HHT pour « Hilbert-Huang Transform » en anglais). La décomposition en modes empiriques consiste à décomposer un signal sous la forme d'une somme d'un signal résiduel et de fonctions de mode intrinsèque (IMF pour « Intrinsic Mode Function » en anglais). Dans la présente demande, ces fonctions de mode intrinsèque sont également appelées « composantes intrinsèques ».

Comme indiqué précédemment, les composantes intrinsèques ne sont pas définies analytiquement. Elles sont plutôt déterminées de façon adaptative en fonction des propriétés du signal.

Une composante intrinsèque (IMF) résultant d'une décomposition en modes empiriques (EMD) doit satisfaire aux exigences suivantes :

- le nombre d'extrema (c'est-à-dire la somme du nombre des maxima locaux et du nombre des minima locaux) et le nombre de passages par zéro de la composante intrinsèque doivent être égaux ou différer au maximum de un ;
- en tout point de la composante intrinsèque, la valeur moyenne de l'enveloppe définie par les maxima locaux et de l'enveloppe définie par les minima locaux est nulle.

Un signal $s(t)$ décomposé par EMD peut alors s'écrire sous la forme :

$$s(t) = r(t) + \sum_{i=1}^{N} c_i(t)$$

Dans cette expression, $r(t)$ correspond au signal résiduel, $N$ est le nombre de composantes intrinsèques de la décomposition EMD, et $c_i$ est la composante intrinsèque d'indice $i$. Chaque composante intrinsèque $c_i(t)$ successive contient des oscillations de fréquence inférieure à celle de la précédente. Le signal résiduel correspond à une tendance générale du signal $s(t)$.

La décomposition en modes empiriques comporte une succession de processus de tamisage (« sifting process » en anglais). Le premier processus de tamisage prend en entrée le signal $s(t)$ directement. Le processus de tamisage correspond à identifier tous les extrema locaux du signal d'entrée, et à relier les maxima locaux, respectivement les minima locaux, par une interpolation par splines cubiques, afin d'obtenir une enveloppe supérieure, respectivement une enveloppe inférieure. Une moyenne entre l'enveloppe supérieure et l'enveloppe inférieure peut alors être calculée et soustraite au signal d'entrée. Si le signal intermédiaire obtenu (soustraction du signal d'entrée avec la moyenne des enveloppes supérieure et inférieure) n'est pas une composante intrinsèque, le processus de tamisage est réitéré sur le signal intermédiaire (qui devient donc le signal d'entrée d'un nouveau processus de tamisage) jusqu'à obtenir une composante intrinsèque. Les processus de tamisage sont répétés jusqu'à obtenir la dernière composante intrinsèque, c'est-à-dire par exemple jusqu'à ce que le signal intermédiaire devienne monotone ou qu'il ne comporte plus qu'un seul extremum local. Le signal restant correspond alors au signal résiduel $r(t)$.

Un critère d'arrêt peut être défini pour le processus de tamisage. Par exemple le critère d'arrêt est satisfait si l'écart-type entre les résultats de deux processus de tamisage successifs est inférieur ou égale à un seuil d'arrêt prédéterminé. Le seuil d'arrêt peut typiquement être compris entre 0.2 et 0.3.

Le document « The empirical mode decomposition and the Hilbert spectrum for non-linear and non-stationary time series analysis », Norden E. Huang et al., Proceedings of the Royal Society of London Series A (1998) 454, p. 903-995, décrit de façon détaillée la décomposition en modes empiriques, notamment dans ses sections 4 et 5.

Des algorithmes de décomposition en modes empiriques sont disponibles dans des bibliothèques de programmation, par exemple en langage MATLAB ou Python.

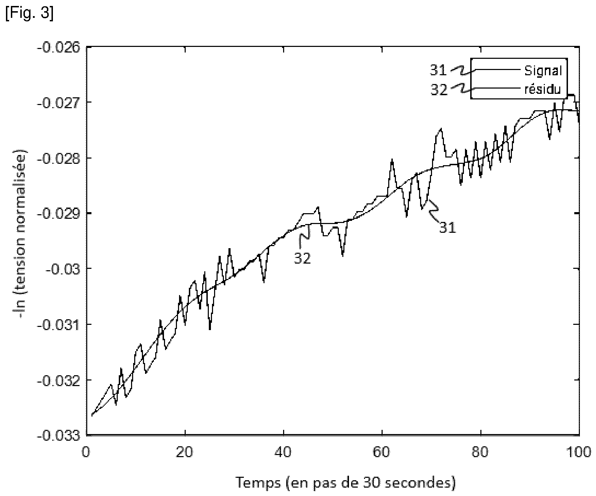

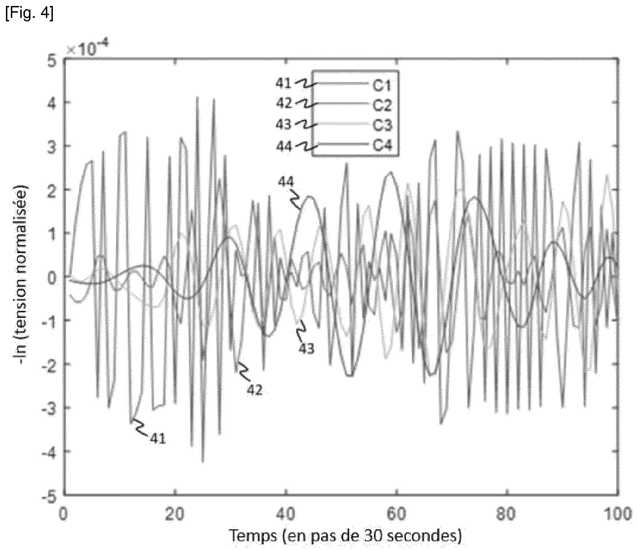

Les graphiques des figures 3 et 4 représentent un exemple de décomposition en modes empiriques d'un signal de relaxation d'une des douze cellules de la batterie. Plus particulièrement, la figure 3 représente le signal 31 de relaxation de la cellule, et le signal résiduel 32 de la décomposition EMD de ce signal 31. La figure 4 représente quatre composantes intrinsèques (composantes $C_1$ à $C_4$, représentées respectivement par les courbes 41 à 44) obtenues par la décomposition EMD du signal 31.

Il convient de noter que, dans d'autres exemples, un nombre différent de composantes intrinsèques pourrait être obtenu. En particulier, le nombre de composantes intrinsèques obtenues lors de la décomposition EMD du signal de relaxation peut varier d'une cellule à l'autre. Le nombre de composantes intrinsèques reste toutefois généralement inférieur à cinq. Il est avantageux de paramétrer le seuil d'arrêt à un niveau relativement bas, de l'ordre de 0.2, pour extraire un maximum d'information du signal de relaxation. Utiliser un seuil d'arrêt plus faible impose des temps de calcul particulièrement importants.

Les composantes intrinsèques obtenues à l'étape 130 sont alors utilisées à l'étape 150 pour déterminer une valeur d'incidence représentative de l'état de santé de la batterie pour la phase de relaxation considérée.

Différentes méthodes peuvent être envisagées pour déterminer la valeur d'incidence associée à la phase de relaxation considérée.

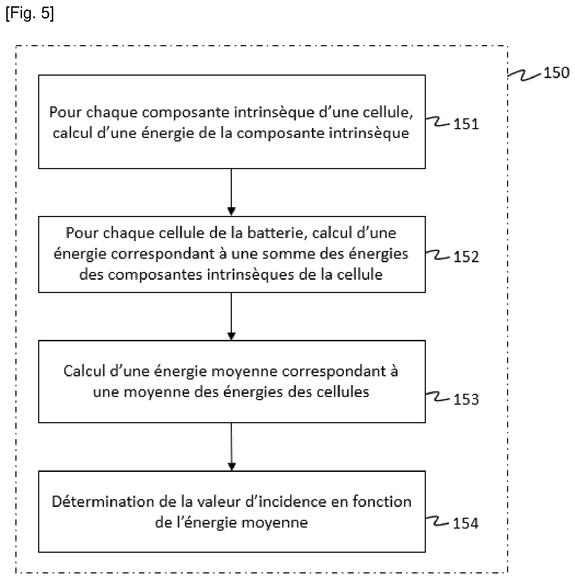

Par exemple, et tel qu'illustré sur la figure 5, la détermination 150 d'une valeur d'incidence peut comporter :

- pour chaque composante intrinsèque d'une cellule, un calcul 151 d'une énergie de ladite composante intrinsèque,
- pour chaque cellule, un calcul 152 d'une énergie de la cellule correspondant à une somme des énergies des composantes intrinsèques de la cellule,
- un calcul 153 d'une énergie moyenne correspondant à une moyenne des énergies des cellules de la batterie,
- une détermination 154 de la valeur d'incidence à partir de l'énergie moyenne calculée pour la phase de relaxation considérée.

L'énergie $E_i$ d'une composante intrinsèque $C_i$ correspond par exemple à l'intégrale du carré de l'amplitude de la composante intrinsèque $C_i$ sur la durée d'acquisition de la phase de relaxation considérée :

$$E_i = \int |c_i(t)|^2 dt$$

L'énergie $E_k$ d'une cellule d'indice $k$ pour la phase relaxation considérée peut alors s'écrire sous la forme :

$$E_k = \sum_{i=1}^{M_k} E_i$$

où $M_k$ est le nombre de composantes intrinsèques obtenues lors de la décomposition EMD du signal de relaxation $x_k$ associé à la cellule d'indice $k$ pour la phase relaxation considérée.

Il convient de noter que rien n'empêcherait, dans une variante, de calculer l'énergie $E_k$ d'une cellule d'indice $k$ en sommant les énergies d'un sous-ensemble seulement des composantes intrinsèques obtenues par la décomposition EMD (par exemple en considérant seulement un nombre maximum prédéfini des premières composantes intrinsèques obtenues par la décomposition EMD ou, comme on le verra par la suite, en écartant certaines composantes intrinsèques jugées non fiables sur un plan statistique).

L'énergie moyenne des énergies des cellules de la batterie, pour la phase de relaxation considérée, peut alors s'écrire sous la forme :

$$\bar{E} = \frac{1}{N_C} \sum_{k=1}^{N_C} E_k$$

La valeur d'incidence de la phase de relaxation considérée peut alors correspondre à l'énergie moyenne $\bar{E}$.

Il convient de noter que rien n'empêcherait, dans des variantes, de calculer la valeur d'incidence d'une façon différente, par exemple en pondérant l'énergie moyenne en fonction de la profondeur de la décharge qui a précédé la phase de relaxation. Rien n'empêcherait non plus de calculer l'énergie moyenne sous la forme d'une moyenne pondérée des énergies des différentes cellules qui composent la batterie. Le choix particulier d'une méthode de calcul de la valeur d'incidence n'est qu'une variante de l'invention.

De façon générale, dans l'invention la valeur d'incidence est calculée sous la forme d'une moyenne d'énergies intrinsèques des cellules de la batterie, l'énergie intrinsèque d'une cellule correspondant à une somme d'énergies de composantes intrinsèques de la cellule. De façon encore plus large, il est envisageable de calculer la valeur d'incidence en utilisant tout type d'indicateur de tendance centrale des énergies intrinsèques des cellules de la batterie (par exemple une médiane des énergies intrinsèques, une moyenne de la valeur minimale et de la valeur maximale des énergies intrinsèques, une moyenne tronquée des énergies intrinsèques, etc.).

La valeur d'incidence déterminée à l'étape 150 peut être exploitée en temps réel pour détecter une défaillance de la batterie à un instant où la défaillance se produit (ou à un instant proche de celui-ci).

Selon un autre exemple, la valeur d'incidence déterminée pour chaque phase de relaxation peut être mémorisée dans un fichier informatique. Un tel fichier peut former une cartographie (ou passeport numérique) de la batterie donnant des indications sur d'éventuelles défaillances que la batterie aurait subies au cours d'une première vie. Dans ce fichier informatique, chaque valeur d'incidence est associée à une information sur l'instant d'occurrence de la phase de relaxation à laquelle elle correspond. Cette information peut par exemple correspondre à une date d'occurrence, avec le jour et éventuellement l'heure à laquelle la phase de relaxation a eu lieu. Cette information pourrait aussi tout simplement correspondre à un numéro de phase de relaxation (ce numéro étant incrémenté à chaque nouvelle phase de relaxation observée par la cellule au cours de sa première vie).

Les inventeurs ont pu observer que les valeurs d'incidence ont tendance à prendre des valeurs relativement élevées, ou bien elles ont tendance à croitre avec le temps, lorsque la batterie est soumise à des conditions environnementales défavorables (par exemple lorsqu'elle est soumise à des températures particulièrement élevées ou particulièrement basses) ou lorsque la batterie est soumise à une fréquence insuffisante de recharges complètes.

En général, un système de gestion de batterie procède à un rééquilibrage des cellules de la batterie en fin de charge, lorsque le taux de charge (SOC) est proche de 100%. Lorsque la batterie n'est pas soumise à une recharge complète, le rééquilibrage des cellules de la batterie ne peut pas avoir lieu. Lorsqu'un rééquilibrage des cellules de la batterie n'est pas effectué de façon suffisamment fréquente, la batterie peut souffrir d'un vieillissement prématuré.

Il est ainsi possible de définir un critère de détection d'une défaillance de la batterie à partir d'une ou plusieurs valeurs d'incidence déterminées pour une ou plusieurs phases de relaxation.

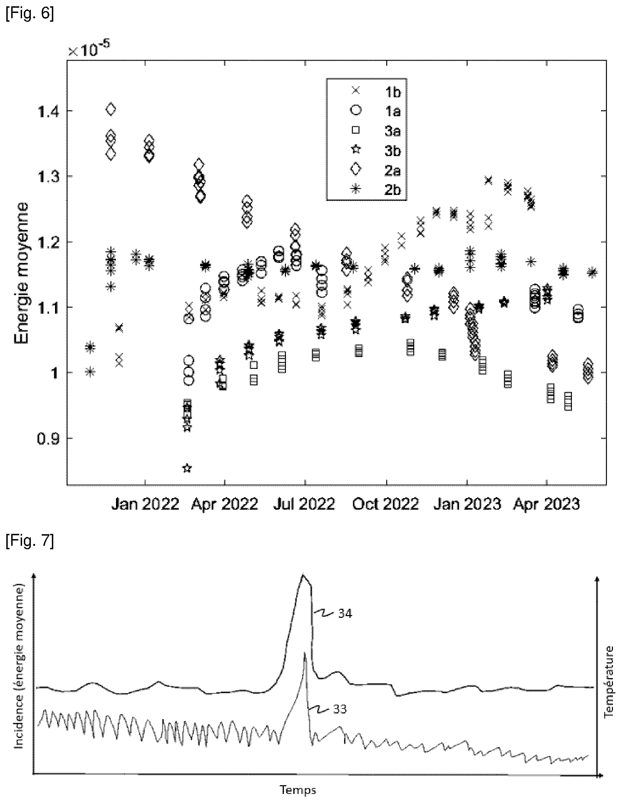

A titre d'exemple, la figure 6 représente des valeurs d'incidence, associées aux dates des phases de relaxation pour lesquelles elles ont été déterminées, pour différentes batteries Lithium-Ion soumises à différentes conditions environnementales et à différents usages pendant une période donnée (entre octobre 2021 et juin 2023).

La batterie notée « 1a », dont les valeurs d'incidence sont représentées sur le graphique de la figure 6 par des ronds, a été testée dans une enceinte climatique à 45°C avec un premier usage qui s'apparente à celui d'une batterie de véhicule électrique avec un enchainement de phases de roulage et de recharges complètes quotidiennes.

La batterie notée « 1b », dont les valeurs d'incidence sont représentées sur le graphique de la figure 6 par des croix, a été testée dans une enceinte climatique à 45°C avec un deuxième usage qui s'apparente à de la régulation de fréquence de réseau électrique, avec des recharges complètes nettement plus espacées (une seule recharge complète par semaine).

La batterie notée « 2a », dont les valeurs d'incidence sont représentées sur le graphique de la figure 6 par des losanges, a été testée dans une enceinte climatique à 25°C avec le premier usage.

La batterie notée « 2b », dont les valeurs d'incidence sont représentées sur le graphique de la figure 6 par des astérisques, a été testée dans une enceinte climatique à 25°C avec le deuxième usage.

La batterie notée « 3a », dont les valeurs d'incidence sont représentées sur le graphique de la figure 6 par des carrés, a été testée avec le premier usage en condition climatique extérieure (températures élevées l'été et froides l'hiver).

La batterie notée « 3b », dont les valeurs d'incidence sont représentées sur le graphique de la figure 6 par des étoiles, a été testée en condition climatique extérieure avec le deuxième usage.

Il apparaît sur la figure 6 que les batteries qui ont été testées avec le deuxième usage (avec une seule recharge complète par semaine) présentent généralement des périodes assez longues au cours desquelles les valeurs d'incidence sont strictement croissantes. Avec le temps, elles finissent par présenter des valeurs d'incidence relativement élevées. En revanche, les batteries qui ont été testées avec le premier usage (avec une recharge complète quotidienne) présentent généralement des valeurs d'incidence plus faibles ou décroissantes. Les batteries soumises à des conditions environnementales défavorables présentent également des valeurs d'incidence généralement plus élevées ou avec de longues périodes de croissance.

A l'étape 160, différents critères peuvent être utilisés, de façon individuelle ou en combinaison, pour détecter une défaillance d'une batterie à partir de la valeur d'incidence déterminée pour une ou plusieurs phases de relaxation.

Selon un premier exemple, il est envisageable de comparer la valeur d'incidence avec un seuil d'incidence prédéterminé, pour une ou plusieurs phases de relaxation. Si la valeur d'incidence est supérieure au seuil pour la phase de relaxation considérée, ou bien si elle reste supérieure au seuil pour un nombre prédéterminé de phases de relaxation consécutives, alors une alerte peut être levée.

Selon un deuxième exemple, il est envisageable de comparer la valeur d'incidence avec une ou plusieurs valeurs d'incidence de phases de relaxation précédentes. Par exemple, si les valeurs d'incidence de plusieurs phases de relaxation consécutives sont croissantes pour un nombre prédéterminé de phases de relaxation consécutives, alors une alerte peut être levée.

Selon un troisième exemple, pour chaque nouvelle phase de relaxation considérée, il est envisageable d'effectuer une interpolation linéaire sur les valeurs d'incidence déterminées respectivement pour la nouvelle phase de relaxation et pour chacun d'un certain nombre de phases de relaxation précédentes, et de comparer la pente de l'interpolation linéaire avec un seuil de pente prédéterminé. Si la pente est supérieure au seuil de pente, alors une alerte peut être levée.

Une défaillance peut être détectée lorsqu'un certain nombre d'alertes est atteint. Lorsqu'une défaillance est détectée au cours de la vie de la batterie, il est envisageable de mettre en place des mesures correctives pour optimiser la durée de vie de la batterie. Par exemple, il est envisageable d'augmenter la fréquence à laquelle une recharge complète (SOC = 100%) est effectuée. De telles dispositions permettent de favoriser la fréquence de rééquilibrage des cellules de la batterie. Selon un autre exemple, et lorsque cela est possible, il est envisageable d'éliminer un facteur environnemental défavorable.

Les différents paramètres à prendre en compte pour ces différents critères de détection utilisés pour l'étape 160 (seuil d'incidence, seuil de pente, durée d'une période de croissance, nombre de phases de relaxation à considérer, nombre d'alertes, etc.) peuvent être déterminés de façon empirique en laboratoire.

Il est à noter que de nombreuses autres variantes sont envisageables pour définir un critère de détection d'une défaillance de la batterie à partir des valeurs d'incidence calculées. Le choix particulier d'un critère n'est qu'une variante de l'invention.

En cas de détection d'une défaillance, il est envisageable d'enregistrer l'occurrence de la défaillance dans une mémoire (par exemple avec la date et l'heure associée). Cela permet, à l'issue d'une période donnée, de faire un bilan du nombre de défaillances détectées durant la période considérée, et d'évaluer l'état de la batterie à l'issue de cette période (par exemple en fin d'une première vie de la batterie). Cette évaluation de l'état de la batterie peut par exemple influencer un choix entre un recyclage ou une réutilisation en seconde vie de la batterie.

Comme cela a été mentionné précédemment, une autre option peut être d'enregistrer les valeurs d'incidence dans une mémoire, et de procéder à une détection des défaillances subies par la batterie à l'issue d'une période donnée (a posteriori), à partir des valeurs d'incidence mémorisées. Dans ce cas, l'étape d'évaluation 160 du critère de détection d'une défaillance de la batterie n'est pas effectuée à la fin d'une phase de relaxation, mais elle est effectuée à une date ultérieure à partir de la valeur d'incidence mémorisée correspondant à ladite phase de relaxation.

Il peut être avantageux de savoir si une défaillance détectée est liée à l'environnement dans lequel la batterie a évolué.

Dans ce but, et tel qu'illustré sur la figure 2, la méthode 100 peut comporter une étape optionnelle de vérification 170 si une défaillance détectée est liée à l'environnement dans lequel la batterie a évolué.

Cette vérification 170 peut notamment comprendre une comparaison, pour une période donnée, des valeurs d'incidence mémorisées pour la batterie pendant cette période avec des valeurs d'incidence déterminées et mémorisées pour au moins une autre batterie soumise au même environnement pendant cette période. Si les valeurs d'incidence observées pour une ou plusieurs autres batteries soumises au même environnement mettent en évidence une évolution anormale similaire pendant une période donnée, alors il est fortement probable que ce comportement anormal soit lié à l'environnement (par exemple à cause d'une augmentation exceptionnelle de la température subie par les différentes batteries pendant cette période).

Alternativement, ou en complément, la vérification 170 peut comprendre une comparaison, pour une période donnée, de mesures d'environnement effectuées et mémorisées pendant cette période avec un seuil prédéterminé. Il peut s'agir par exemple de mesures de la température subie par la batterie.

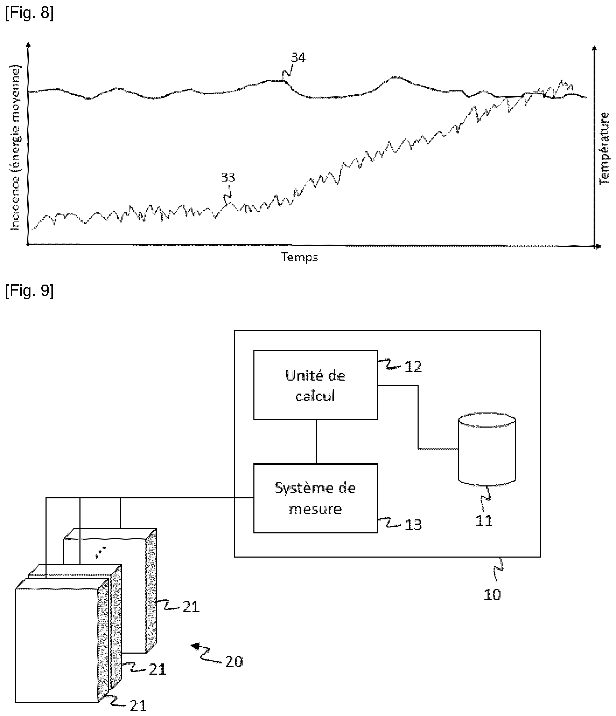

A titre d'exemple, les figures 7 et 8 illustrent l'évolution au cours du temps de la valeur d'incidence d'une batterie (courbe 33) ainsi que l'évolution au cours du temps, pendant la même période, de la température subie par la batterie (courbe 34).

Dans l'exemple illustré à la figure 7, la défaillance mise en évidence par le pic de valeur d'incidence est très probablement liée à l'environnement car un pic similaire est observé au même moment pour la température subie par la cellule. Au contraire, à la figure 8, l'augmentation continue de la valeur d'incidence ne semble pas liée à l'environnement.

Si une défaillance est liée à l'environnement, il peut être envisageable de prendre une mesure corrective au niveau de l'environnement de la batterie, et la défaillance aura potentiellement un impact limité dans le temps. Une défaillance qui n'est pas liée à l'environnement peut être liée à l'usage qui est fait de la batterie (notamment à la fréquence des charges complètes de la batterie). Là encore, une mesure corrective est possible (augmentation de la fréquence des charges complètes de la batterie). Une défaillance peut toutefois également être liée à un défaut de fabrication de la batterie, ou à une dégradation précoce d'au moins une cellule de la batterie. Une telle défaillance peut nécessiter une mise en sécurité de la batterie pour éviter un risque d'accident (emballement thermique, risque d'incendie ou d'explosion, etc.).

Tel qu'illustré sur la figure 2, la méthode 100 selon l'invention peut également comporter une étape optionnelle d'analyse 140 de la fiabilité statistique des éléments utilisés pour déterminer la valeur d'incidence. Cette analyse 140 de fiabilité statistique peut notamment permettre d'estimer si l'énergie d'une composante intrinsèque d'une cellule présente une valeur aberrante, ou si l'énergie intrinsèque d'une cellule présente une valeur aberrante. Si tel est le cas, la composante intrinsèque et/ou l'énergie intrinsèque jugée non fiable peut être filtrée (c'est-à-dire qu'elle n'est pas prise en compte) dans la détermination 150 de la valeur d'incidence. Alternativement, il est envisageable de considérer que la valeur d'incidence elle-même n'est pas suffisamment fiable. Dans ce cas, la phase de relaxation est écartée et elle n'est pas considérée pour le suivi de l'état de santé de la batterie.

Selon un premier exemple, l'analyse 140 de fiabilité statistique peut comporter, pour chaque composante intrinsèque du signal de relaxation d'une cellule, un calcul d'une entropie de cette composante intrinsèque. Par exemple, une composante intrinsèque dont l'entropie est trop faible (inférieure à un seuil d'entropie prédéterminé) est filtrée.

Selon un autre exemple, l'analyse 140 de fiabilité statistique peut comporter, pour chaque cellule, un calcul d'une entropie d'une somme des composantes intrinsèques du signal de relaxation de la cellule (par exemple pour la somme de l'ensemble des composantes intrinsèques obtenues par la décomposition EMD, ou pour la somme d'un nombre maximum prédéfini des premières composantes intrinsèques obtenues par la décomposition EMD). Par exemple, une cellule pour laquelle la somme des composantes intrinsèques présente une entropie trop faible est filtrée.

Différentes méthodes de calcul d'entropie peuvent être envisagés, comme par exemple un calcul d'entropie de Shannon, ou un calcul d'entropie de Kolmogorov. Un seuil d'entropie de Shannon compris entre 0.25 et 0.5 peut notamment être envisagé.

Selon encore un autre exemple, l'analyse 140 de fiabilité statistique peut comporter :

- une comparaison d'une énergie d'une composante intrinsèque d'une cellule avec un seuil ou avec les énergies des autres composantes intrinsèques de la cellule, et/ou
- une comparaison d'une énergie d'une cellule avec un seuil ou avec les énergies des autres cellules de la batterie, et/ou
- une comparaison de la valeur d'incidence déterminée pour la phase de relaxation considérée avec un seuil ou avec d'autres valeurs d'incidence calculées pour des phases de relaxation précédentes.

Différents tests statistiques peuvent être envisagés pour comparer ces énergies entre elles, malgré un nombre relativement faible de données, comme par exemple : test de Peirce, test de Chauvenet, test de Grubbs, etc.

L'analyse 140 de fiabilité statistique peut également comporter une combinaison des exemples présentés ci-dessus (les différents critères pour filtrer une composante intrinsèque, une cellule, voire la valeur d'incidence peuvent être utilisés conjointement).

La figure 9 représente schématiquement un exemple de réalisation d'un dispositif 10 pour détecter une défaillance d'une batterie 20 Lithium-Ion. Le dispositif 10 comporte notamment une mémoire 11, un système 13 de mesure et une unité 12 de calcul connectée à la mémoire 11 et au système 13 de mesure. La mémoire 11 peut notamment être utilisée pour stocker les valeurs d'incidence calculées et/ou des occurrences de défaillances détectées (par exemple avec la date et l'heure associées) pour une évaluation a posteriori de l'état de santé de la batterie. Si l'on cherche uniquement à faire une détection de défaillance en temps réel, cette mémoire 11 n'est pas indispensable.

Le système 13 de mesure est configuré pour fournir des mesures de tension effectuées au niveau de chaque cellule 21 de la batterie 20 pendant au moins une phase de relaxation faisant suite à une décharge de la batterie.

L'unité 12 de calcul est configurée pour mettre en œuvre la méthode 100 selon l'un quelconque des modes de mise en œuvre décrits ci-avant.

Les valeurs d'incidence calculées pour des phases de relaxation observées par la batterie 20 au cours de sa vie peuvent être mémorisées dans la mémoire 11.

Le dispositif 10 peut en outre comporter un capteur configuré pour mesurer au moins un paramètre physique de l'environnement dans lequel évolue la batterie 20 (par exemple un capteur de température).

L'unité 12 de calcul peut également être configuré pour obtenir des valeurs d'incidence d'une ou plusieurs autres batteries soumises à un même environnement que la batterie 20.

La communication entre le système 13 de mesure et l'unité 12 de calcul (notamment pour la transmission des mesures de tension) peut être mise en œuvre par des moyens de communication filaires ou par des moyens de communication sans fil. Le système 13 de mesure et l'unité 12 de calcul peuvent former une seule entité physique (c'est-à-dire qu'ils peuvent être intégrés dans un même boîtier, par exemple dans un système de gestion de batterie (BMS)). Rien n'empêcherait toutefois que le système 13 de mesure et l'unité 12 de calcul fassent chacun partie d'une entité physique différente. Il peut même être envisagé que l'unité 12 de calcul soit intégrée dans un serveur distant configuré pour collecter des données de plusieurs batteries.

La description ci-avant illustre clairement que, par ses différentes caractéristiques et leurs avantages, la présente invention atteint les objectifs fixés. En particulier, le suivi de la moyenne des énergies intrinsèques des cellules de la batterie permet de détecter des défaillances de la batterie (l'énergie intrinsèque d'une cellule correspond à une somme des énergies des composantes intrinsèques du signal de relaxation de la cellule). La détection de défaillance peut être effectuée en temps réel, pour prendre le cas échéant des mesures correctives visant optimiser la durée de vie de la batterie, ou bien a posteriori, à la fin d'une première vie de la batterie, pour évaluer la pertinence de réutiliser la batterie dans une deuxième vie.

**Revendications**

1. Méthode (100) pour détecter une défaillance d'une batterie (20) Lithium-Ion, ladite batterie (20) comportant plusieurs cellules (21), la méthode (100) comportant, pour au moins une phase de relaxation faisant suite à une phase de décharge de la batterie :

    - pour chaque cellule (21) :

        ◦ une collecte (110) de plusieurs mesures de tension au niveau de la cellule (21) pendant ladite phase de relaxation,
        ◦ une formation (120) d'un signal de relaxation en calculant, pour chaque mesure de tension collectée pendant ladite phase de relaxation, un logarithme d'une valeur normalisée de la mesure de tension,
        ◦ une décomposition (130) en modes empiriques du signal de relaxation afin d'en obtenir une représentation sous la forme d'une somme d'un signal résiduel et d'une ou plusieurs composantes intrinsèques,

- une détermination (150) d'une valeur d'incidence représentative d'un état de santé de la batterie (20), pour ladite phase de relaxation, à partir des composantes intrinsèques ainsi obtenues pour les différentes cellules (21) de la batterie (20),

- une évaluation (160) d'un critère de détection d'une défaillance de la batterie (20) en fonction de la valeur d'incidence de ladite phase de relaxation.

2. Méthode (100) selon la revendication 1 dans laquelle, pour une cellule (21) d'indice *k*, une valeur du signal de relaxation à un instant *t* peut s'écrire sous la forme :

$$x_k(t) = -\ln\left(\frac{V_k(t)}{\left(\frac{U_B(t)}{N_C}\right)}\right)$$

où $V_k(t)$ est une tension mesurée aux bornes de la cellule (21) d'indice *k*, $U_B(t)$ est une tension mesurée aux bornes de la batterie, $N_C$ est le nombre de cellules (21) de la batterie (20), et ln est l'opérateur logarithme népérien.

3. Méthode (100) selon l'une quelconque des revendications 1 à 2 dans laquelle la détermination (150) de la valeur d'incidence pour la phase de relaxation considérée comporte :

   - pour chaque composante intrinsèque d'une cellule (21), un calcul (151) d'une énergie de ladite composante intrinsèque,
   - pour chaque cellule (21), un calcul (152) d'une énergie de la cellule correspondant à une somme des énergies des composantes intrinsèques de la cellule (21),
   - un calcul (153) d'une énergie moyenne correspondant à une moyenne des énergies des cellules (21) de la batterie (20),
   - une détermination (154) de la valeur d'incidence à partir de l'énergie moyenne calculée pour la phase de relaxation considérée.

4. Méthode (100) selon l'une quelconque des revendications 1 à 3 dans laquelle l'évaluation (160) d'un critère de détection comporte une comparaison de la valeur d'incidence avec un seuil d'incidence prédéterminé, pour une ou plusieurs phases de relaxation consécutives.

5. Méthode (100) selon l'une quelconque des revendications 1 à 4 dans laquelle l'évaluation (160) d'un critère de détection comporte une comparaison de la valeur d'incidence avec une ou plusieurs valeurs d'incidence de phases de relaxation précédentes.

6. Méthode (100) selon l'une quelconque des revendications 1 à 5 dans laquelle l'évaluation (160) d'un critère de détection comporte une vérification si les valeurs d'incidence de plusieurs phases de relaxation consécutives sont croissantes pour un nombre prédéterminé de phases de relaxation consécutives.

7. Méthode (100) selon l'une quelconque des revendications 1 à 6 dans laquelle l'évaluation (160) d'un critère de détection comporte un calcul d'une pente d'une interpolation linéaire effectuée pour un ensemble de plusieurs valeurs d'incidence correspondant à plusieurs phases de relaxation consécutives, et une comparaison de la pente avec un seuil de pente prédéterminé.

8. Méthode (100) selon l'une quelconque des revendications 1 à 7 comportant en outre, pour chaque phase de relaxation, une analyse (140) de fiabilité statistique d'éléments permettant la détermination (150) de la valeur d'incidence, et un filtrage de l'un au moins des éléments suivants s'il est jugé non fiable :

   - une composante intrinsèque d'une cellule (21),
   - une cellule (21) de la batterie (20),
   - la valeur d'incidence.

9. Méthode (100) selon la revendication 8 dans laquelle l'analyse (140) de fiabilité statistique comporte :

   - pour chaque composante intrinsèque du signal de relaxation d'une cellule (21), un calcul d'une entropie de la composante intrinsèque, et/ou
   - pour chaque cellule (21), un calcul d'une entropie à partir d'une somme des composantes intrinsèques du signal de relaxation de la cellule (21).

10. Méthode (100) selon l'une quelconque des revendications 8 à 9 dans laquelle l'analyse (140) de fiabilité statistique comporte :

   - une comparaison d'une énergie d'une composante intrinsèque d'une cellule (21) avec un seuil ou avec les énergies des autres composantes intrinsèques de la cellule (21), et/ou
   - une comparaison d'une énergie d'une cellule (21) avec un seuil ou avec les énergies des autres cellules (21) de la batterie (20), et/ou
   - une comparaison de la valeur d'incidence déterminée pour la phase de relaxation considérée avec un seuil ou avec d'autres valeurs d'incidence calculées pour des phases de relaxation précédentes.

11. Méthode (100) selon l'une quelconque des revendications 1 à 10 dans laquelle, lorsqu'une défaillance est détectée, la méthode (100) comporte en outre une vérification (170) si la défaillance détectée est liée à l'environnement dans lequel la batterie (20) a évolué, ladite vérification (170) comprenant :

- une comparaison, pour une période donnée comportant ladite au moins une phase de relaxation, de valeurs d'incidence déterminées pour la batterie (20) pendant ladite période avec des valeurs d'incidence déterminées pour au moins une autre batterie (22) soumise au même environnement pendant ladite période, et/ou
- une comparaison, pour une période donnée comportant ladite au moins une phase de relaxation, de mesures d'environnement effectuées pendant ladite période avec un seuil prédéterminé.

**12.** Méthode (100) selon l'une quelconque des revendications 1 à 11 dans laquelle, lorsqu'une défaillance est détectée, la méthode (100) comporte une mémorisation de l'occurrence de la défaillance, pour une analyse a posteriori d'un état de santé de la batterie.

**13.** Méthode (100) selon l'une des revendications 1 à 12 dans laquelle la phase de décharge qui précède la phase de relaxation présente une profondeur de décharge au moins égale à 60%, voire de préférence au moins égale à 90%.

**14.** Dispositif (10) pour détecter une défaillance d'une batterie (20) Lithium-Ion, ladite batterie (20) comportant plusieurs cellules (21), ledit dispositif (10) comportant :

- un système (13) de mesure configuré pour fournir des mesures de tension effectuées au niveau de chaque cellule (21) pendant au moins une phase de relaxation faisant suite à une décharge de la batterie,
- une unité (12) de calcul connectée au système (13) de mesure, ladite unité (12) de calcul étant configurée pour mettre en œuvre la méthode (100) selon l'une quelconque des revendications 1 à 13.

**15.** Système de gestion de batterie, ou BMS, comportant un dispositif (10) selon la revendication 14.

[Fig. 1]

[Fig. 2]

Pour au moins une phase de relaxation :

```
Pour chaque cellule :

    ┌─────────────────────────────────────┐
    │ Collecte de plusieurs mesures de     │
    │ tension pendant la phase de          │ ⎨ 110
    │ relaxation                           │
    └─────────────────────────────────────┘
                    │
                    ▼
    ┌─────────────────────────────────────┐
    │ Formation d'un signal relaxation     │ ⎨ 120
    └─────────────────────────────────────┘
                    │
                    ▼
    ┌─────────────────────────────────────┐
    │ Décomposition en modes empiriques    │ ⎨ 130
    │ (EMD) du signal de relaxation        │
    └─────────────────────────────────────┘
```

100

```
    ┌─────────────────────────────────────┐
    │ Analyse de fiabilité statistique     │ ⎨ 140
    └─────────────────────────────────────┘
                    │
                    ▼
    ┌─────────────────────────────────────┐
    │ Détermination d'une valeur           │
    │ d'incidence à partir des composantes │
    │ intrinsèques des décompositions EMD  │ ⎨ 150
    │ obtenues pour les différentes        │
    │ cellules de la batterie              │
    └─────────────────────────────────────┘
                    │
                    ▼
    ┌─────────────────────────────────────┐
    │ Evaluation d'un critère de détection │ ⎨ 160
    │ d'une défaillance de la batterie     │
    └─────────────────────────────────────┘
                    │
                    ▼
    ┌─────────────────────────────────────┐
    │ Vérification si la défaillance       │
    │ détectée est liée à l'environnement  │ ⎨ 170
    │ dans lequel la cellule a évolué      │
    └─────────────────────────────────────┘
```

[Fig. 3]

[Fig. 4]

[Fig. 5]

```
                                                    ⌇─150
┌──────────────────────────────────────────┐
│ Pour chaque composante intrinsèque d'une  │
│ cellule, calcul d'une énergie de la       │ ⌇─151
│ composante intrinsèque                    │
└──────────────────────────────────────────┘
                    │
                    ▼
┌──────────────────────────────────────────┐
│ Pour chaque cellule de la batterie,       │
│ calcul d'une énergie correspondant à une  │ ⌇─152
│ somme des énergies des composantes        │
│ intrinsèques de la cellule                │
└──────────────────────────────────────────┘
                    │
                    ▼
┌──────────────────────────────────────────┐
│ Calcul d'une énergie moyenne correspondant│
│ à une moyenne des énergies des cellules   │ ⌇─153
└──────────────────────────────────────────┘
                    │
                    ▼
┌──────────────────────────────────────────┐
│ Détermination de la valeur d'incidence en │
│ fonction de l'énergie moyenne             │ ⌇─154
└──────────────────────────────────────────┘
```

[Fig. 6]

[Fig. 7]

[Fig. 8]

[Fig. 9]

Europäisches
Patentamt

European
Patent Office

Office européen
des brevets

**RAPPORT DE RECHERCHE EUROPEENNE**

Numéro de la demande

EP 25 19 9799

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | KR 2024 0041264 A (LG ENERGY SOLUTION LTD [KR]) 29 mars 2024 (2024-03-29) * alinéas [0004], [0031], [0046] - [0063], [0074]; figure 1 * ----- | 1-15 | INV. G01R31/392 G01R31/396 |
| A | WO 2020/084211 A1 (PSA AUTOMOBILES SA [FR]) 30 avril 2020 (2020-04-30) * alinéas [0022] - [0026], [0033] - [0035], [0050] - [0056], [0083]; figure 1 * ----- | 1-15 | |

**DOMAINES TECHNIQUES RECHERCHES (IPC)**

G01R

Le présent rapport a été établi pour toutes les revendications

| Lieu de la recherche | Date d'achèvement de la recherche | Examinateur |
|---|---|---|
| Munich | 8 février 2026 | Jedlicska, István |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..........................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 25 19 9799

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-02-2026

| Document brevet cité au rapport de recherche | Date de publication | Membre(s) de la famille de brevet(s) | Date de publication |
|---|---|---|---|
| KR 20240041264 A | 29-03-2024 | KR 20240041264 A<br>KR 20250162434 A | 29-03-2024<br>18-11-2025 |
| WO 2020084211 A1 | 30-04-2020 | CN 112912745 A<br>EP 3870985 A1<br>FR 3087392 A1<br>WO 2020084211 A1 | 04-06-2021<br>01-09-2021<br>24-04-2020<br>30-04-2020 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017146608 A1
- US 20220381849 A1
- EP 3324197 A1

**Littérature non-brevet citée dans la description**

- **R. JEANNE-BROU**. *Anisotropic ionic transport properties in solid PEO based electrolytes*
- **NORDEN E. HUANG et al.** The empirical mode decomposition and the Hilbert spectrum for non-linear and non-stationary time series analysis. *Proceedings of the Royal Society of London Series A*, 1998, vol. 454, 903-995